# EUROPÄISCHE PATENTSCHRIFT

(11) **EP 1 238 311 B1**
(45) Veröffentlichungstag und Bekanntmachung des Hinweises auf die Patenterteilung: **02.08.2006**
(21) Anmeldenummer: 00976041.4
(22) Anmeldetag: 17.11.2000
(51) Int. Cl.: G03F 7/00, B81C 1/00, H01F 41/04

(54) **FLACHSPULE UND LITHOGRAPHISCHES VERFAHREN ZUR HERSTELLUNG VON MIKROBAUTEILEN**
FLAT COIL AND LITHOGRAPHIC METHOD FOR PRODUCING MICROCOMPONENTS
BOBINE PLATE ET PROCEDE LITHOGRAPHIQUE POUR PRODUIRE DES MICROCOMPOSANTS

(30) Priorität: 19.11.1999 DE 19955975
(43) Veröffentlichungstag der Anmeldung: 11.09.2002
(73) Patentinhaber: INSTITUT FÜR MIKROTECHNIK MAINZ GmbH, 55129 Mainz (DE)
(72) Erfinder: SCHMITZ, Felix, 55118 Mainz (DE); NIENHAUS, Matthias, Dr., 55127 Mainz (DE); LACHER, Manfred, 55116 Mainz (DE)
(74) Vertreter: Fuchs Mehler Weiss & Fritzsche
(86) Internationale Anmeldenummer: PCT/EP2000/011447
(87) Internationale Veröffentlichungsnummer: WO 2001/037045

(56) Entgegenhaltungen:
- EP-A- 0 592 094
- EP-A- 0 607 680
- EP-A- 0 851 295
- DE-C- 4 400 315
- US-A- 5 877 924

## Beschreibung

Die Erfindung betrifft ein lithographisches Verfahren zur Herstellung von Mikrobauteilen mit metallischen Bauteilstrukturen im sub-Millimeterbereich, bei dem ein Resistmaterial mittels selektiver Belichtung und Herauslösen der unbelichteten Bereiche strukturiert und die Zwischenräume zwischen den Resiststrukturen mittels eines galvanischen Verfahrens mit Metall zur Bildung der metallischen Bauteilstrukturen aufgefüllt werden. Die Erfindung betrifft auch ein lithographisches Verfahren zur Herstellung von Mikrobauteilen mit Bauteilstrukturen aus vernetzbarem Resistmaterial gemäß dem Oberbegriff von Anspruch 10 sowie eine Flachspule nach Anspruch 16.

Derartige lithographische Verfahren werden zur Herstellung unterschiedlichster metallischer Mikrobauteile verwendet. Besondere Bedeutung haben diese Verfahren zur Herstellung von Mikrospulen für elektrische Mikromotoren erlangt. Um einerseits die Leistung der Mikromotoren zu erhöhen und andererseits die Bauhöhe zu verringern, müssen diese Mikrospulen einen großen Füllfaktor bzw. eine hohe Strukturdichte und eine möglichst geringe Dicke aufweisen. Ferner müssen diese Mikrobauteile freitragend sein.

Die bisher bekannten Spulen für Mikromotoren erfüllen diese Bedingungen nicht.

Aus der DE 41 05 999 A1 ist eine Folienspule bekannt, die in einer supraleitenden Vorrichtung verwendet wird. Es handelt sich um geschichtete Folienspulen, bei denen auf einem isolierenden Substrat eine Leiterplatte aufgebracht wird, die durch Ätzen so bearbeitet wird, daß spiralige Leiterbahnen erzeugt werden. Als Material wird Kupfer und Aluminium in Betracht gezogen. Das Ätzen hat jedoch den Nachteil, daß bei den Mikrostrukturen eine Unterätzung auftritt, so daß diese in ihrem Aspektverhältnis, das typischerweise ≤ 1 liegt, stark eingeschränkt werden. Es lassen sich technologiebedingt nur Strukturen mit relativ geringen Höhen herstellen. Typische Höhen für die Feinstleitertechnik liegen bei maximal 15 µm, während die untere Grenze für die Leiterbahnbreite bei etwa 50 µm bei einem minimalen Leiterbahnabstand von 60 µm liegt. Aufgrund der relativ großen Abstände der Wicklungen ist somit auch der Füllfaktor relativ gering.

Aus Proc. SPIE Vol. 3680B-65 Paris, France, 30. März bis 1. April 1999 "Micromachining and Microfabrication" mit dem Titel "Design and realization of a penny-shaped micromotor" von M. Nienhaus et al. ist es bekannt, auf einem Trägerwerkstoff zunächst eine Kupferstartschicht aufzubringen, auf der über eine Bindungsschicht ein Resistmaterial aufgetragen wird. Dieses Resistmaterial wird mittels einer Maske und UV-Strahlung strukturiert und anschließend werden die Resiststrukturen mittels eines galvanischen Verfahrens mit Metall aufgefüllt. Das zwischen den Metallstrukturen befindliche Resistmaterial wird entfernt, so daß lediglich die metallischen Strukturen übrig bleiben. Eine so hergestellte Spule ist nicht freitragend und muß auf einer Stützfolie zusammen mit weiteren Spulen aufgebracht werden.

Als Resistmaterial wird SU-8-Resistmaterial (Handelsname der Shell Chemical) verwendet, unter dem ein vernetzbares Polymere verstanden wird, das beispielsweise in J. Micromechanics, Microengineering 7(1997) S. 121-124 beschrieben wird. Es handelt sich hierbei um ein Epoxyderivat des Bis-Phenol-Novolacs, das bereits für die Herstellung von Mikrostrukturen Verwendung findet. Dieses Material zeichnet sich insbesondere dadurch aus, daß Strukturen mit großen Aspektverhältnissen hergestellt werden können. Aufgrund der Vernetzung bei der Belichtung wird eine Veränderung des Brechungsindex dieses Materials erzeugt, so daß aus dem Resistmaterial Strukturen mit Wellenleitereigenschaften hergestellt werden. Man erhält dadurch bei der Belichtung mittels Masken letztendlich senkrechte Wände, die beim Herausätzen der unbelichteten Bereiche erhalten bleiben.

Das bekannte Verfahren sieht vor, daß das SU-8-Resistmaterial entfernt wird. Dadurch, daß das Material allerdings vernetzt ist, bereitet das Herauslösen erhebliche Schwierigkeiten. Insofern sind spezielle Lösungsmittel notwendig, die allerdings im Prinzip nur eine Aufquellung des Resistmaterials bewirken. Ein Herauslösen ist nur dann möglich, wenn die metallischen Strukturen einen entsprechenden großen Abstand von typischerweise > 100 µm aufweisen, so daß sich das Lösungsmittel zwischen den metallischen Strukturen voll entfalten kann. Damit ist die Strukturdichte bei derart hergestellten Mikrobauteilen sehr beschränkt. Da auch zur Vereinzelung der Mikrobauteile das Resistmaterial entfernt werden muß, ist der Arbeitsaufwand erheblich.

Mikrobauteile aus Kunststoff, z.B. aus SU-8, können über lithographische Verfahren hergestellt werden, wobei zunächst eine metallische Negativform, z.B. über galvanische Abformung, hergestellt wird. Diese Negativform wird dann als Formwerkzeug für einen Spritzgußprozeß zur Fertigung des Kunststoff-Mikrobauteils verwendet. Dieses in der EP 0 851 295 A1 beschriebene Verfahren ist aufgrund der Vielzahl der Verfahrensschritte aufwendig und die Herstellung von Mikrobauteilen mit Hinterschneidungen ist nicht möglich.

Es ist daher Aufgabe der Erfindung, ein Verfahren zur Herstellung von Mikrobauteilen aus Metall oder Kunststoff bereitzustellen, das eine verfahrensimmanente Vereinzelung der Mikrobauteile ermöglicht. Ferner sollen mit diesem Verfahren auch freitragende Mikrobauteile, insbesondere Flachspulen für Mikromotoren, sowie Mikrobauteile aus Kunststoff mit Hinterschneidungen herstellbar sein, wobei das Verfahren auch eine Massenfertigung ermöglichen soll. Außerdem soll eine stabile Flachspule für Mikromotoren geschaffen werden.

Diese Aufgabe wird bezüglich metallischer Mikrobauteile mit einem lithographischen Verfahren gelöst, bei dem während der Herstellung des Mikrobauteils eine dreidimensional strukturierte metallische Opferschicht hergestellt wird, die das Mikrobauteil begrenzt, und bei dem zur Vereinzelung des Mikrobauteils die Opferschicht entfernt wird.

Das Mikrobauteil ist dadurch während der Herstellung derart in das Opfermaterial bzw. zwischen den Opferstrukturen eingebettet, daß vorzugsweise nur eine Seite, beispielsweise die Oberseite, freiliegt.

Die dreidimensional strukturierte Opferschicht bietet den Vorteil, daß beim Entfernen, insbesondere beim Wegätzen der Opferschicht, das Mikrobauteil nicht nur von dem Substrat gelöst wird, sondern daß gleichzeitig auch die Außenkontur des Mikrobauteils freigelegt und von der Umgebungsstruktur gelöst werden kann. Es ist somit zum Vereinzeln lediglich ein Arbeitsvorgang notwendig.

Als Resistmaterial kann sogenanntes vernetzbares Negativ-Resistmaterial sowie photostrukturierbares Epoxy-Harz und hier insbesondere SU-8 Material verwendet werden. Mittels diesem Verfahren können beispielsweise Strukturen mit einer Höhe von 700 µm hergestellt werden.

Das Verfahren kann auch mit Röntgenlithographie in Kombination mit Positiv- und Negativ-Resistmaterial durchgeführt werden. Hierbei wird als Positiv-Resistmaterial vorzugsweise PMMA und als Negativ-Resistmaterial ein Negativ-Resistmaterial auf Novolac-Basis für Röntgenstrahlung eingesetzt.

Vorzugsweise wird die dreidimensional strukturierte Opferschicht aus mindestens einer horizontalen Opferschicht und mindestens einer vertikalen Opferschicht gebildet.

Vorzugsweise werden bei der Strukturierung des Resistmaterials auch die Strukturen für die vertikale Opferschicht ausgebildet. Dies bedeutet, daß bei der selektiven Belichtung und dem Herauslösen der unbelichteten Bereiche gleichzeitig auch die Strukturen für die vertikale Opferschicht freigelegt werden können.

Hierbei ist es insbesondere von Vorteil, wenn für die metallischen Bauteilstrukturen und für die dreidimensional strukturierte Opferschicht dasselbe Metall verwendet wird. Wenn beispielsweise die metallischen Bauteilstrukturen aus Kupfer bestehen sollen, wird auch für die dreidimensional strukturierte Opferschicht ebenfalls Kupfer verwendet.

Auch die galvanische Abscheidung zur Bildung der Bauteilstrukturen und die galvanische Abscheidung für die vertikale Opferschicht werden vorzugsweise gleichzeitig durchgeführt. Dies bedeutet, daß für die Herstellung der Opferschichten keine zusätzlichen Verfahrensschritte notwendig sind, wodurch sich das Verfahren zur Massenfertigung von Mikrobauteilen eignet.

Vorzugsweise wird das die metallischen Bauteilstrukturen umgebende Resistmaterial nicht entfernt. Dadurch wird das Resistmaterial Teil des Mikrobauteils und dient als mechanische Verbindungs- und Haltestruktur. Zusätzliche Maßnahmen zur Stabilisierung des Mikrobauteils, insbesondere bei flachen Mikrobauteilen, sind nicht erforderlich. Ein Substrat, auf dem die Mikrobauteile bei der Herstellung gehalten und stabilisiert werden, ist nicht mehr erforderlich. Durch den Wegfall eines Substrates kann insbesondere bei Flachspulen die Bauhöhe erheblich verringert werden. Außerdem wird die Handhabung der Mikrobauteile deutlich erleichtert.

Vorzugsweise werden als metallische Bauteilstrukturen Leiterbahnen einer Flachspule hergestellt. Die freitragende Flachspule ist über Bondpads wie ein SMT-Bauelement zu montieren bzw. kontaktieren. Bei dieser Ausführungsform dient das Resistmaterial nicht nur zur Stabilisierung, so daß eine freitragende Spule hergestellt werden kann, sondern auch gleichzeitig als elektrischer Isolator zwischen den Leiterbahnen. In einer bevorzugten Ausführungsform wird eine vollständig einbettende Isolation dadurch hergestellt, daß das Resistmaterial in Art einer Hülle die metallischen Strukturen und das Mikrobauteil umfaßt.

Dadurch, daß das Resistmaterial nicht herausgelöst wird, können insbesondere bei der Verwendung von SU-8-Resistmaterial Leiterbahnen mit sehr großem Aspektverhältnis (> 1), vorzugsweise bis zu einem Aspektverhältnis von 15 und darüber hergestellt werden. Dadurch wird es möglich, beispielsweise Flachspulen zu fertigen, die lediglich eine Wicklungslage aufweisen. Die zwingende Mehrlagigkeit, die bei den herkömmlichen Flachspulen notwendig war, entfällt. Dadurch werden die Herstellungskosten solcher Mikrobauteile erheblich gesenkt. Vorzugsweise wird man jedoch zwei Wicklungslagen im Hinblick auf die Anschlüsse der Leiterbahnen bevorzugen.

Die Aufgabe wird bezüglich der Bauteile mit Bauteilstrukturen aus vernetzbarem Resistmaterial dadurch gelöst, daß
a) auf ein Substrat eine horizontale, metallische Opferschicht aufgebracht wird.
b) daß auf die Opferschicht Resistmaterial aufgebracht wird,
c) daß aus dem Resistmaterial mittels selektiver Belichtung und Herauslosen der nichtbelichteten Bereiche die Bauteilstrukturen hergestellt werden,
d) daß die Zwischenräume zwischen den Bauteilstrukturen mittels eines galvanischen Verfahrens mit Metall zur Bildung mindestens einer vertikalen Opferschicht aufgefüllt werden und
e) daß zur Vereinzelung der Mikrobauteile die Opferschichten entfernt werden.

Da bei diesem Verfahren die Herstellung metallischer Bauteilstrukturen entfällt, wird durch die Strukturierung des Resistmaterials nicht die Negativstruktur, sondern die Positivstruktur des Bauteils hergestellt. Dadurch, daß die Zwischenräume zwischen den aus Resistmaterial bestehenden Bauteilstrukturen aus einem Metall bestehen, das beispielsweise herausgeätzt werden kann, und diese Bauteilstrukturen bereits auf einer Opferschicht angebracht sind, kann durch Entfernen der insgesamt dreidimensional strukturierten Opferschicht das Bauteil bzw. die Bauteile freigelegt werden. Auch bei diesem Verfahren sind die Mikrobauteile in die dreidimensional strukturierte Opferschicht eingebettet, so daß zum Vereinzeln lediglich ein Arbeitsvorgang notwendig ist.

Vorzugsweise werden die Schritte b) bis d) in dieser Reihenfolge mindestens zweifach nacheinander durchgeführt, was insbesondere dann von Vorteil ist, wenn Bauteile mit Hinterschneidungen in vertikaler Richtung hergestellt werden sollen.

Wenn das Mikrobauteil nicht sofort bestimmungsgemäß eingesetzt wird und beispielsweise für einen Transport gehalten und aufbewahrt werden muß, ist es von Vorteil, wenn bei der Herstellung der vertikalen Opferschicht mindestens eine die Opferschicht unterbrechende Anbindungsfahne aus Resistmaterial hergestellt wird. Mittels dieser Anbindungsfahne oder den Anbindungsfahnen kann das Mikrobauteil an der das Mikrobauteil umgebenden Struktur gehalten und transportiert werden.

Hierbei ist es von Vorteil, wenn während der Herstellung des Mikrobauteils eine das Mikrobauteil über die mindestens eine Anbindungsfahne haltende Magazinstruktur aus Resistmaterial hergestellt wird.

Vorzugsweise werden mindestens zwei Mikrobauteile in einer solchen Magazinstruktur gleichzeitig hergestellt. Je nach Größe der Mikrobauteile können über 100 Mikrobauteile gleichzeitig in einer solchen Magazinstruktur gefertigt werden, so daß eine Massenfertigung ermöglicht wird.

Vorzugsweise wird als Magazinstruktur ein Wafer aus diesem Resistmaterial hergestellt, in dem die Mikrobauteile angeordnet und über die Anbindungsfahnen gehalten sind. Der Wafer ist aufgrund seiner größeren Abmessung einfach handhabbar und die Mikrobauteile sind innerhalb des Wafers geschützt angeordnet. Wenn die Mikrobauteile benötigt werden, können diese beispielsweise mittels eines Sauggreifers erfaßt und aus dem Wafer herausgenommen werden, wobei die Anbindungsfahnen aufgrund ihrer vorzugsweise geringen Dicke von lediglich einigen Mikrometern problemlos brechen.

Die Flachspule für Mikromotoren ist dadurch gekennzeichnet, daß die Leiterbahnen in isolierendes Resistmaterial eingebettet sind.

Vorzugsweise wird ein mittels UV-Strahlung strukturierbares und vernetzbares Resistmaterial verwendet.

Vorzugsweise sind die Leiterbahnen an eine aus dem Resistmaterial herausgeführte metallische Anschlußfläche (Bondpad) angeschlossen. Dadurch können die Flachspulen wie ein SMT-Bauteil (Surface Mounted Bauteil) eingesetzt werden. Diese metallische Anschlußfläche stellt den einzigen metallischen Kontakt dar, weil die Flachspule vorzugsweise vollständig von Resistmaterial umschlossen ist. Die Flachspule weist somit eine gekapselte Bauweise auf.

Dadurch, daß große Aspektverhältnisse und eine große Strukturdichte mittels des erfindungsgemäßen Verfahrens erreicht werden können, erhält man bei der Herstellung von Flachspulen einen großen Füllfaktor. Die Breite des Resistmaterials zwischen den einzelnen Leiterbahnen liegt zwischen 5 und 15 µm, vorzugsweise bei 10 µm und die Höhe im Bereich von 40 bis 80 µm, vorzugsweise bei 60 µm. Die Isolation kann somit auf ein Minimum reduziert werden, was einer Isolation bei Drähten von etwa 5 µm Isolationsschicht entsprechen würde.

Zusätzlich zu den metallischen Strukturen, die das Mikrobauteil ausmachen, wie z.B. die Leiterbahnen einer Flachspule, können auch zusätzliche metallische Strukturen gleichzeitig hergestellt werden, die beispielsweise an der Innen- oder Außenkante der Flachspule ausgebildet eine Armierung und somit eine Versteifung des Mikrobauteils gewährleisten oder andererseits eine Passung bilden. Eine Flachspule kann somit auf einer Welle aufgesetzt werden, wodurch die Stabilität und die Präzision der Bauteilposition im bestimmungsgemäßen System weiter erhöht wird.

Solche Armierungen können auch bei den Mikrobauteilen aus Resistmaterial vorgesehen sein. Dies kann beispielsweise dadurch realisiert werden, daß Opferstrukturen in dem Mikrobauteil hergestellt werden, die aber beim Herauslösen der Opferstruktur während des Vereinzelungsvorgangs ausgespart werden.

Beispielhafte Ausführungsformen der Erfindung werden nachfolgend anhand der Zeichnungen näher erläutert.

Es zeigen:
- Fig. 1: eine Draufsicht auf einen Wafer mit mehreren Flachspulen für Mikromotoren,
- Fig. 2: die Draufsicht auf eine solche Flachspule,
- Fign. 3a-3q: Schnittdarstellungen eines Spulenabschnitts zur Erläuterung des Herstellungsprozesses für eine Flachspule mit zwei Wicklungslagen,
- Fign. 4a+4b: einen Teilschnitt zur Verdeutlichung der Anbindungsfahnen, und
- Fig. 5: eine Schnittdarstellung zur Erläuterung der Herstellung eines Mikrobauteils aus Resistmaterial
- Fign. 6a-6f: Schnittdarstellungen zur Erläuterung einer weiteren Ausführung der Herstellung von Mikrospulen.

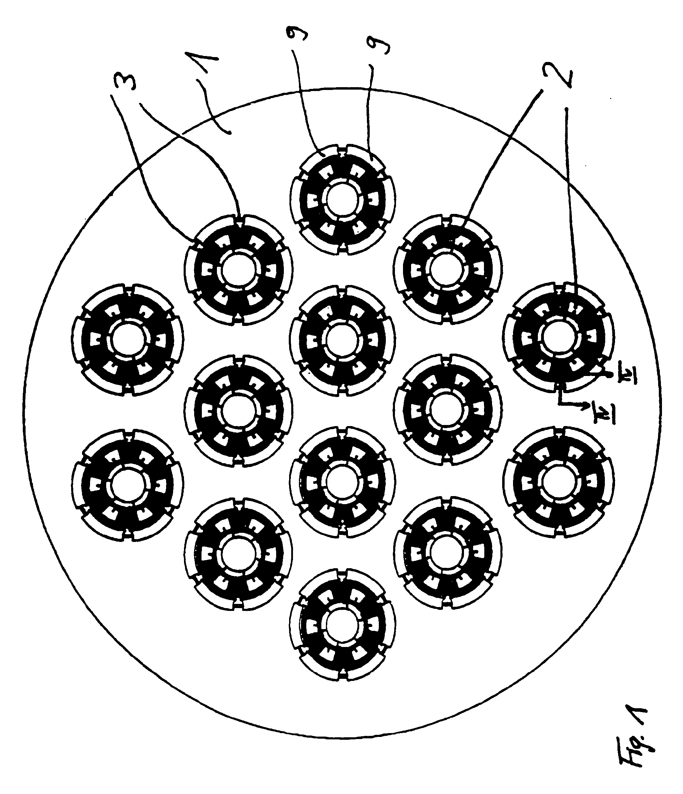

In der Fig. 1 ist als Magazinstruktur ein Wafer 1 aus Resistmaterial dargestellt, in dem eine Vielzahl runder Flachspulen 2 angeordnet ist, die über Anbindungsfahnen 3 mit dem Wafermaterial verbunden sind. Zwischen den Anbindungsfahnen 3, der Spule 2 und dem Wafer 1 befinden sich bogenförmige Freiräume 9, die durch das Entfernen der noch zu erläuternden vertikalen Opferschicht entstehen. Sämtliche Spulen 2 einschließlich des Wafers 1 wurden gleichzeitig hergestellt.

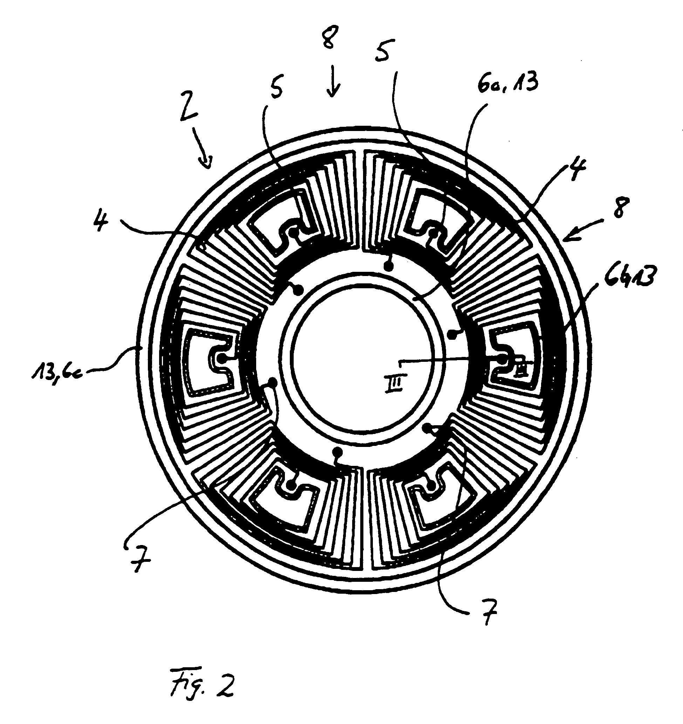

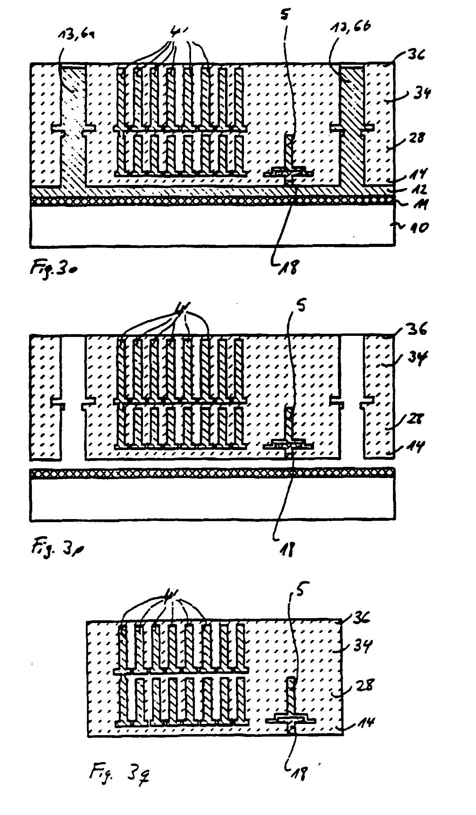

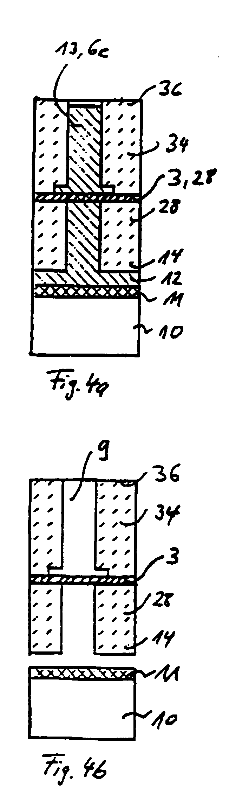

In der Fig. 2 ist die Draufsicht auf eine Spule 2 vergrößert dargestellt, die mehrere aus Leiterbahnen 4 bestehende Wicklungen 8 aufweist. Diese Wicklungen 8 sind im Innenbereich mit sogenannten Anschlußpads 5 und Durchkontaktierungen 7 für darunter- oder darüberliegende Wicklungen verbunden. Ferner sind die vertikalen Opferschichten 13 dargestellt, die in der Fig. 2 noch nicht entfernt wurden, wobei die umgebende Magazinstruktur weggelassen sowie die Anbindungsfahnen 3 nicht zu sehen sind. Im Spuleninneren ist als vertikale Opferschicht 13 ein Vereinzelungsring 6a in Form eines Metallringes dargestellt. Auch innerhalb der Wicklungen 8 sind Vereinzelungsringe 6b sowie ein die gesamte Spule 2 umgebender Vereinzelungsring 6c zu sehen. Die Anbindungsfahnen 3 sind nicht zu sehen, weil sie sich innerhalb des Vereinzelungsrings 6c befinden, wie dies die Fig. 4a zeigt. Nach dem Wegätzen dieser Vereinzelungsringe 6a,b und c steht die Spule 2 zur weiteren Verwendung zur Verfügung.

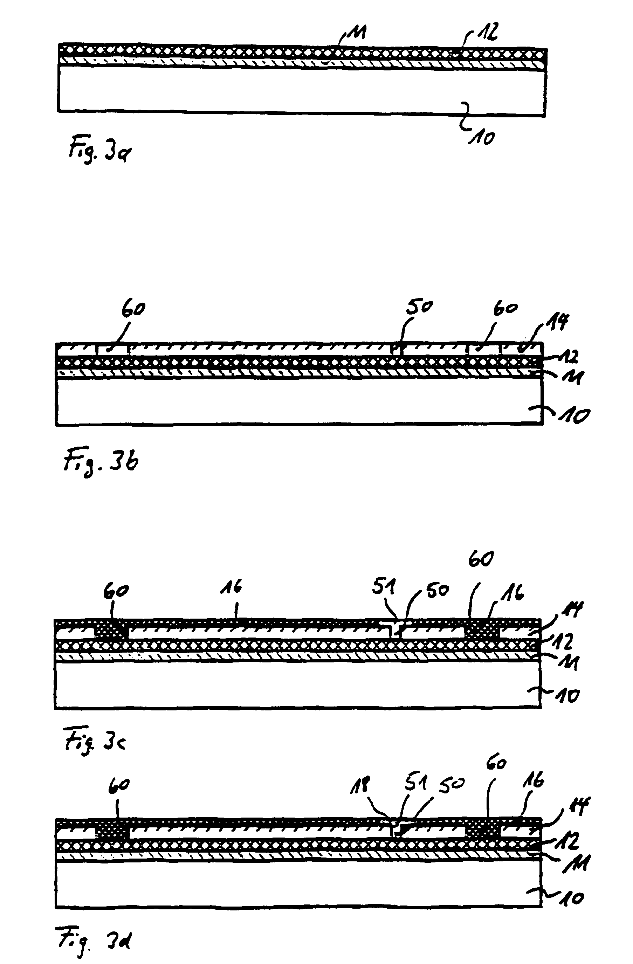

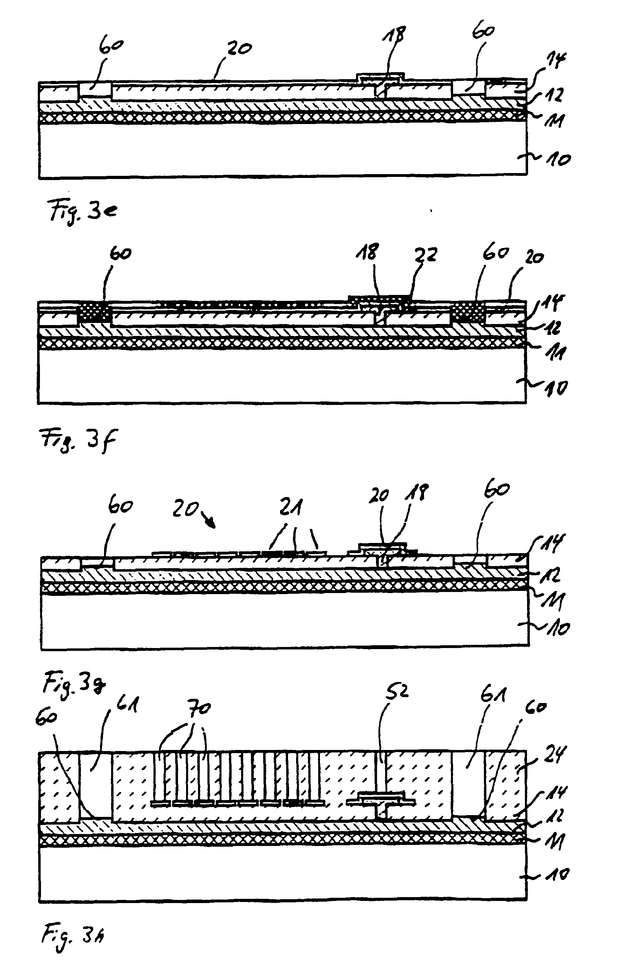

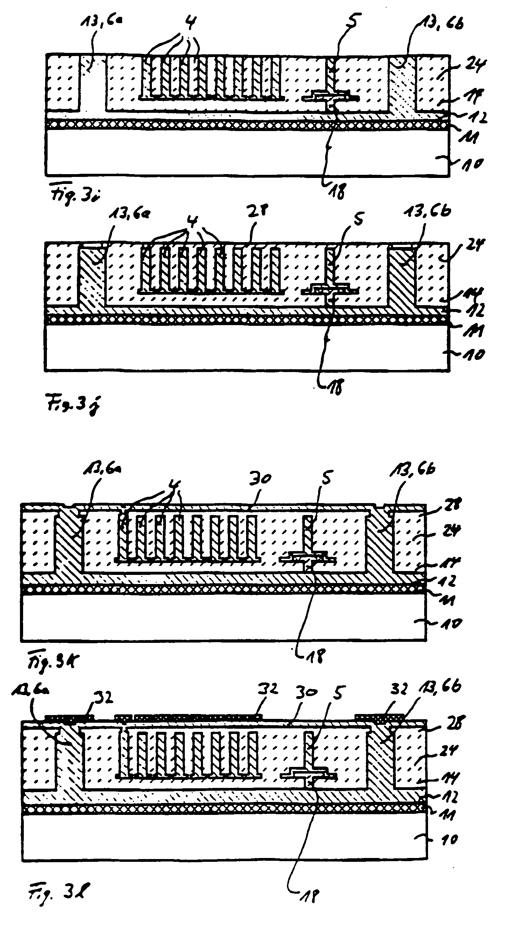

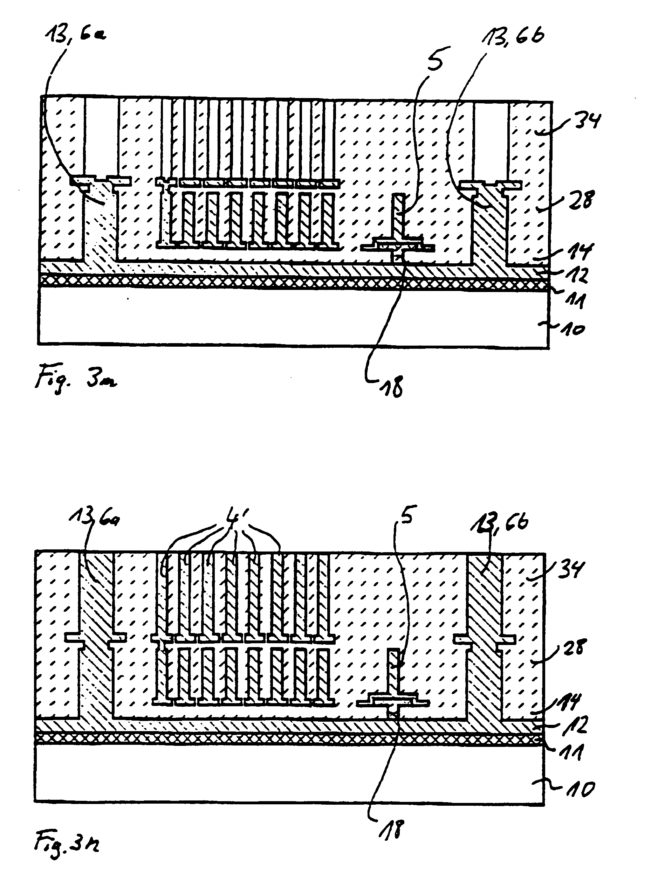

In den Fign. 3a-3q wird der Herstellungsprozeß einer solchen Spule 2, die aus zwei Wickungslagen besteht, näher erläutert, wobei der Abschnitt der Spule längs der Linie III-III in Fig. 2 gewählt wurde. Ausgehend von einem Träger 10, der aus Silizium bestehen kann, wird zunächst eine Startschicht 11 aus Titan und dann eine horizontale Opferschicht 12 aus Kupfer aufgebracht. Die Dicke dieser Opferschicht 12 liegt bei 1 µm.

Im Anschluß daran wird auf die Opferschicht 12 eine Haftschicht z.B. aus Polyimid und darauf eine erste Resistschicht 14 aus SU-8-Material der Dicke 20 µm aufgebracht. Mit einem an sich bekannten Verfahren wird mittels einer Maske und UV-Belichtung eine Strukturierung dieser ersten Resistschicht 14 durchgeführt, so daß eine Anschlußstruktur 50 und zwei Vereinzelungsstrukturen 60 gebildet werden.

Im nächsten in der Fig. 3c gezeigten Verfahrensschritt wird auf die so erzeugte Spulenbasis der ersten Resistschicht 14 eine erste Photolackschicht 16 mit einer Dicke von etwa 2,2 µm aufgebracht, die im Bereich der bereits geschaffenen Anschlußstruktur 50 strukturiert wird (Anschlußstruktur 51). In einem in der Fig. 3d gezeigten weiteren Verfahrensschritt wird dort ein Ätzstop galvanisch abgeschieden. Bei dem Ätzstopmaterial, das mit dem Bezugszeichen 18 versehen ist, handelt es sich vorzugsweise um Nickel. Dieses Ätzstopmaterial 18 ist notwendig, damit beim Wegätzen der Opferschicht 12 im Bereich des Anschlusses das nachfolgend aufgebrachte elektrisch leitende Material nicht entfernt wird.

In der Fig. 3e ist die Photolackschicht 16 bereits entfernt worden und es wird eine erste galvanische Startschicht 20 aus Kupfer aufgebracht. Dadurch erhöht sich auch die Schichtdicke des Kupfermaterials in den Vereinzelungsstrukturen 60.

Im nächsten Verfahrensschritt (Fig. 3f) wird mittels einer zweiten Photolackschicht 22 diese Startschicht 20 strukturiert, so daß Startflächen 21 für die anschließenden Leiterbahnenstrukturen geschaffen werden. Diese Startflächen 21 sind etwas breiter ausgebildet als die späteren Leiterbahnenstrukturen (s. Fig. 3g), was damit vorteilhaft zusammenhängt, daß die Maskenpositionierung für die Strukturierung der weiteren Schichten nicht mit solcher Genauigkeit erfolgen muß, daß die nachfolgenden Bauteilstrukturen exakt auf diesen Startflächen aufliegen.

Nach dieser Strukturierung wird - wie in der Fig. 3h gezeigt ist - eine zweite Resistschicht 24 aus SU-8-Material aufgebracht. Diese Schicht 24 wird, wie zuvor die erste Resistschicht 14, strukturiert, so daß Spulenstrukturen 70 und die Fortsetzung der Vereinzelungsstrukturen 60 (Vereinzelungstruktur 61) sowie der Anschlußstrukturen 50,51 (Anschlußstruktur 52) gebildet werden.

Im nächsten Verfahrensschritt werden diese Strukturen galvanisch mittels Metall aufgefüllt, so daß sich die in der Fig. 3i dargestellte Struktur bildet. Durch das Auffüllen dieser Resiststrukturen werden die Vereinzelungsringe 6a und 6b, das Anschlußpad 5 und die Leiterbahnen 4 gebildet. Die Spule wäre zu diesem Zeitpunkt bereits fertig, es kann jedoch, wie in den Fign. 3j-3q gezeigt wird, noch eine weitere Wicklungslage aufgebracht werden. Zu diesem Zweck wird eine dritte Resistschicht 28 aufgetragen, die wiederum strukturiert und anschließend mit einer zweiten galvanischen Startschicht 30 belegt wird.

Die Beschichtungs- und Strukturierungsvorgänge mittels der dritten Photolackschicht 32, vierter Resistschicht 34 und fünfter Resistschicht 36 gemäß der Fign. 3l-3o entsprechen den zuvor beschriebenen Strukturierungs- und Beschichtungsvorgängen.

Wie in der Fig. 3i bis 3o zu sehen ist, erstrecken sich die vertikalen Opferschichten 13 in Form der Vereinzelungsringe 6a-6b von der horizontalen Opferschicht 12 vertikal nach oben über beide Wicklungslagen hinweg.

In der Fig. 3p sind die Opferschichten 12,13 entfernt, so daß die Spule 2 vereinzelt werden kann. In der Fig. 3q ist die vereinzelte Spule bzw. der entsprechende Abschnitt der vereinzelten Spule dargestellt.

In den Fign. 4a und 4b ist ein Ausschnitt längs der Linie IV-IV der in der Fig. 1 gezeigten Spule 2 dargestellt. Die vertikale Opferschicht 13 in Form des Vereinzelungsrings 6c ist durch die Schicht 28 in einem geringen Umfangsabschnitt unterbrochen, wodurch eine aus typischerweise mehreren Anbindungsfahnen 3 gebildet wird. Da die Schichtdicke der Schicht 28 nur wenige Mikrometer beträgt, ist nach dem Entfernen der vertikalen Opferschicht 13 lediglich diese Anbindungsfahne 3 vorhanden, die beim Ergreifen und Herausnehmen der Spule durchbricht.

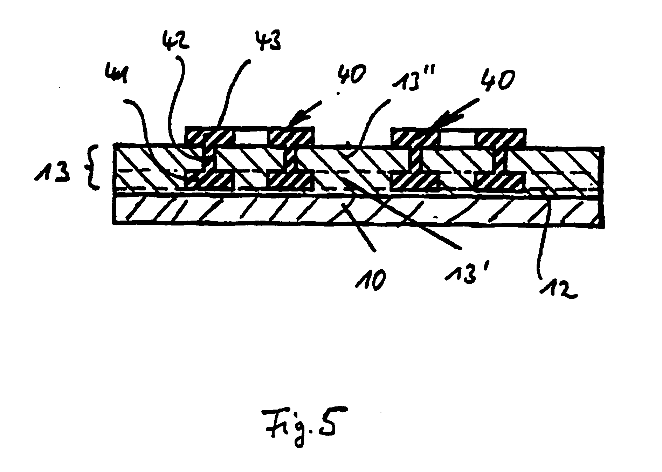

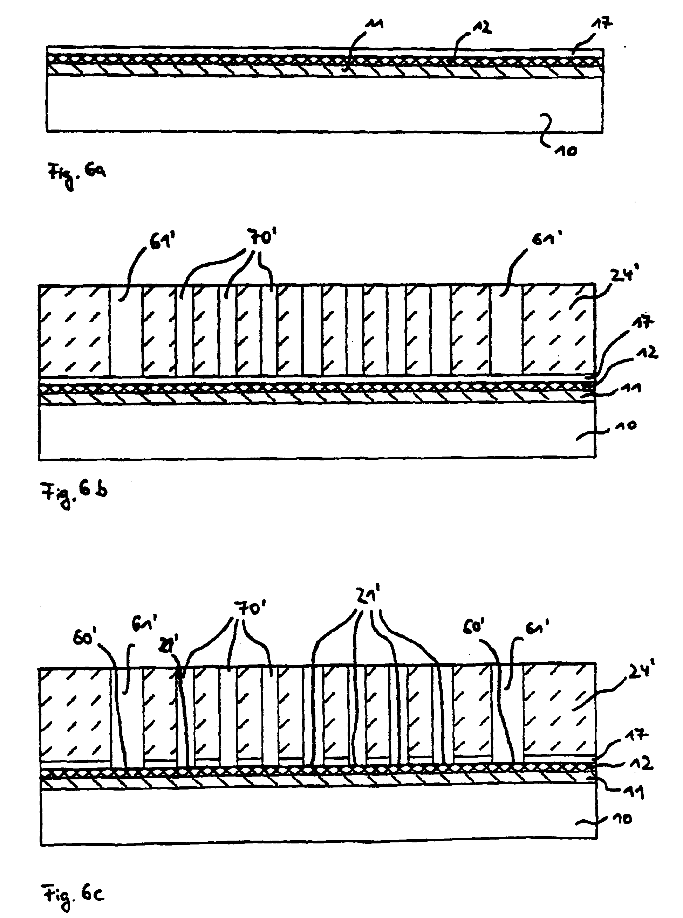

In der Fig. 5 wird die Fertigung von zwei Mikroringen 40 aus vernetzbarem Resistmaterial veranschaulicht. Auf einem Träger 10 wird zunächst eine horizontale Opferschicht 12 aufgebracht. Da die Mikroringe aufgrund ihres H-förmigen Querschnitts in vertikaler Richtung Hinterschneidungen aufweisen, müssen insgesamt drei Resistschichten mit der entsprechenden Strukturierung aufgebracht werden. Dies bedingt auch das Aufbringen von zwei Teil-Opferschichten 13' und 13", die zusammen die vertikale Opferschicht 13 bilden. Zur Herstellung der beiden auf der horizontalen Opferschicht 12 aufgebrachten Resist/Opferschichten sind die Verfahrensschritte b) bis d) gemäß Anspruch 10 zweimal nacheinander auszuführen. Nach dem Entfernen der dreidimensional strukturierten Opferschicht 12,13 liegen die einzelnen Mikroringe 40 vor.

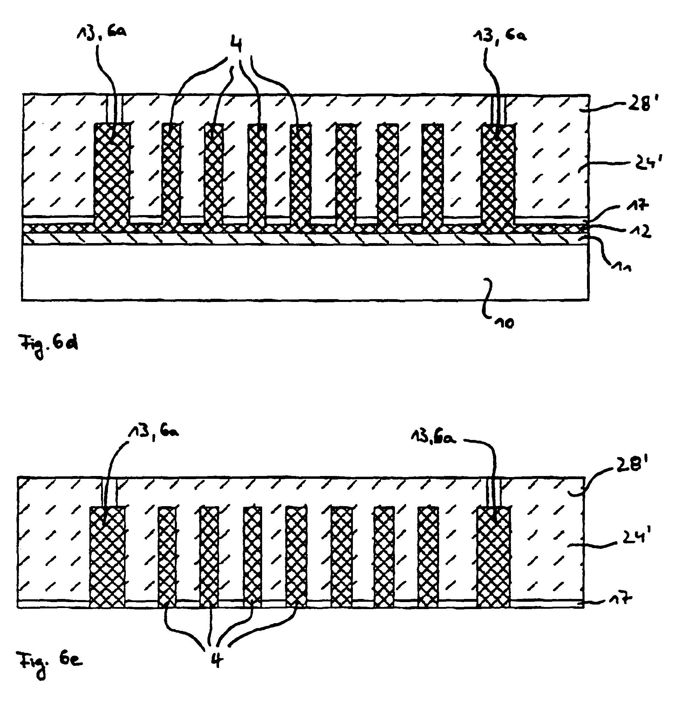

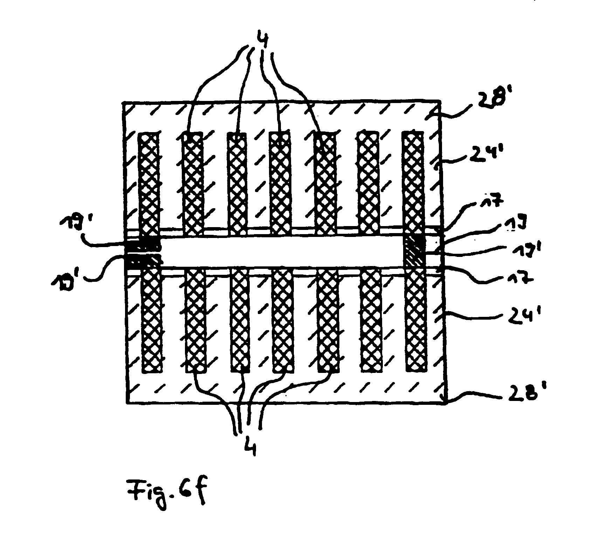

In den Fign. 6a bis 6f ist die Herstellung von Mikrospulen gemäß einem modifizierten Verfahren dargestellt.

Auf einen Träger 10, der aus Silizium bestehen kann, wird zunächst eine Startschicht 11 aus Titan und dann eine horizontale Opferschicht 12 aus Kupfer mit einer Dicke von vorzugsweise 1 µm aufgebracht (Fig. 6a), was insoweit der Fig. 3a entspricht. Im Anschluß daran wird auf die Opferschicht 12 eine Haftschicht 17 z.B. aus Polyimid aufgebracht.

Mit an sich bekannten Verfahren wird gemäß Fig. 6b dann auf diese Polyimidschicht 17 eine Resistschicht 24' aus SU8-Material aufgebracht. Diese Schicht wird mittels einer Maske und UV-Belichtung derart strukturiert, daß Spulenstrukturen 70' und Vereinzelungsstrukturen 61' gebildet werden.

Im nächsten Schritt wird die Haftschicht z.B. aus Polyimid aus den Spulenstrukturen 70' und Vereinzelungsstrukturen 61' weggeätzt, um hierdurch die horizontale Opferschicht aus Kupfer als Startflächen 21' bzw. 60' für die anschließend zu bildenden Leiterbahnen 4 und vertikalen Opferschichten verwenden zu können (Fig. 6c).

Daraufhin werden die Spulenstrukturen 70' und Vereinzelungsstrukturen 61' gleichzeitig mittels Metall aufgefüllt, so daß die Leiterbahnen 4 und vertikalen Opferschichten 13 bzw. die Vereinzelungsringe 6a und 6b gebildet werden.

Anschließend wird eine zweite horizontale Resistschicht 28' zur Einbettung der Spulenstrukturen 70' aufgetragen. Diese Resistschicht 28' wird in den Bereichen der Vereinzelungsstrukturen 61' strukturiert, um die vertikalen Opferschichten 13 bzw. die Vereinzelungsringe 6a und 6b freizulegen (Fig. 6d).

Anschließend zur Herstellung der einlagigen Spule wird in einem weiteren Schritt gemeinsam der Träger 10, die Startschicht 11 aus Titan und die horizontale Opferschicht 12 aus Kupfer durch vorzugsweise Wegätzen dieser Schichten entfernt (Fig. 6e).

Hierdurch wird erreicht, daß die vertikale Opferschicht die Mikrobauteile in der Magazinstruktur fixiert, so daß die Mikrobauteile beispielsweise bei deren Transport nicht nur von den Anbindungsfahnen gehalten werden. Zur Vereinzelung der Mikrobauteile, insbesondere einlagigen Spulen, werden dann die vertikalen Opferschichten 13 bzw. Vereinzelungsringe 6a und 6b und die Anbindungsfahnen aus Resistmaterial entfernt.

Gemäß einer zweiten Ausführungsform wird über die durch Strukturierung in den Bereichen der Vereinzelungsstrukturen 61' freigelegten vertikalen Opferschichten 13 bzw. Vereinzelungsringe 6a und 6b zunächst die vertikale Opferschicht 13 und dann auch die horizontale Opferschicht 12 aus Kupfer, die Startschicht 11 aus Titan und der Träger 10 durch Wegätzen entfernt. Hierdurch wird erreicht, daß die Mikrobauteile, insbesondere einlagigen Spulen, in der Magazinstruktur nur noch über die Anbindungsfahnen gehalten werden.

Zur Herstellung der zweilagigen Spule werden dann die einlagigen Spulen aus der Magazinstruktur entnommen und zwei mit dem beschriebenen Verfahren hergestellte einlagige Spulen durch Kombination, insbesondere durch beidseitiges Verkleben auf einer Kontaktfolie 19 zu einer zweilagigen Mikrospule zusammengefügt. Die Kontaktfolie weist hierzu entsprechende Kontaktflächen 19' auf, die dann mit den Spulenstrukturen 4 in Kontakt stehen (Fig. 6f).

### Bezugszeichen

- 1: Wafer
- 2: Spule
- 3: Anbindungsfahne
- 4: Leiterbahn
- 5: Anschlußpad
- 6a,b,c: Vereinzelungsring
- 7: Durchkontaktierung
- 8: Wicklung
- 9: Freiraum
- 10: Träger
- 11: Titanschicht
- 12: horizontale Opferschicht
- 13: vertikale Opferschicht
- 13': Teilschicht
- 13": Teilschicht
- 14: erste Resistschicht
- 16: erste Photolackschicht
- 17: Haftschicht
- 18: Ätzstopmaterial
- 19: Kontaktfolie
- 19': Kontaktfläche
- 20: erste galvanische Startschicht
- 21: Startfläche
- 22: zweite Photolackschicht
- 24: zweite Resistschicht
- 28: dritte Resistschicht
- 30: zweite galvanische Startschicht
- 32: dritte Photolackschicht
- 34: vierte Resistschicht
- 36: fünfte Resistschicht
- 40: Mikroring
- 41: unterer Ringabschnitt
- 42: mittlerer Ringabschnitt
- 43: oberer Ringabschnitt
- 50: Anschlußstruktur
- 51: Anschlußstruktur
- 52: Anschlußstruktur
- 60: Vereinzelungsstruktur
- 61: Vereinzelungsstrukrtur
- 70: Spulenstruktur

## Patentansprüche

1. Lithographisches Verfahren zur Herstellung von Mikrobauteilen mit metallischen Bauteilstrukturen im sub-Millimeterbereich, bei dem ein Resistmaterial mittels selektiver Belichtung und Herauslösen der unbelichteten Bereiche strukturiert und die Zwischenräume zwischen den Resiststrukturen mittels eines galvanischen Verfahrens mit Metall zur Bildung der metallischen Bauteilstrukturen aufgefüllt werden, **dadurch gekennzeichnet,**
**daß** während der Herstellung des Mikrobauteils eine dreidimensional strukturierte metallische Opferschicht hergestellt wird, die das Mikrobauteil begrenzt, und
**daß** zur Vereinzelung des Mikrobauteils die Opferschicht entfernt wird.

2. Verfahren nach Anspruch 1, **dadurch gekennzeichnet, daß** die dreidimensional strukturierte Opferschicht aus mindestens einer horizontalen Opferschicht und mindestens einer vertikalen Opferschicht gebildet wird.

3. Verfahren nach Anspruch 1 oder 2, **dadurch gekennzeichnet, daß** bei der Strukturierung des Resistmaterials auch die Strukturen für die vertikale Opferschicht ausgebildet werden.

4. Verfahren nach einem der Ansprüche 1 bis 3, **dadurch gekennzeichnet, daß** für die metallischen Bauteilstrukturen und für die dreidimensional strukturierte Opferschicht dasselbe Metall verwendet wird.

5. Verfahren nach einem der Ansprüche 1 bis 4, **dadurch gekennzeichnet, daß** die galvanische Abscheidung zur Bildung der Bauteilstrukturen und die galvanische Abscheidung für die vertikale Opferschicht gleichzeitig durchgeführt werden.

6. Verfahren nach einem der Ansprüche 1 bis 5, **dadurch gekennzeichnet, daß** das die metallischen Bauteilstrukturen umgebende Resistmaterial nicht entfernt wird.

7. Verfahren nach einem der Ansprüche 1 bis 6, **dadurch gekennzeichnet, daß** als metallische Bauteilstrukturen Leiterbahnen einer Flachspule hergestellt werden.

8. Verfahren nach Anspruch 7, **dadurch gekennzeichnet, daß** zur Herstellung der Leiterbahnen strukturierte Startschichten für die nachfolgende galvanische Abscheidung verwendet werden.

9. Verfahren nach einem der Ansprüche 7 oder 8, **dadurch gekennzeichnet, daß** Leiterbahnen mit einem Aspektverhältnis > 1 hergestellt werden.

10. Lithographisches Verfahren zur Herstellung von Mikrobauteilen mit Bauteitstrukturen aus vernetzbarem Resistmaterial, **dadurch gekennzeichnet,**
a) daß auf ein Substrat eine horizontale, metallische Opferschicht aufgebracht wird,
b) daß auf die Opferschicht Resistmaterial aufgebracht wird,
c) daß aus dem Resistmaterial mittels selektiver Belichtung und Herauslösen der nichtbelichteten Bereiche die Bauteilstrukturen hergestellt werden,
d) daß die Zwischenräume zwischen den Bauteilstrukturen mittels eines galvanischen Verfahrens mit Metall zur Bildung mindestens einer vertikalen Opferschicht aufgefüllt werden, und
e) daß zur Vereinzelung des Mikrobauteils die Opferschichten entfernt werden.

11. Verfahren nach Anspruch 10, **dadurch gekennzeichnet, daß** die Schritte b) bis d) in dieser Reihenfolge mindestens zweifach nacheinander ausgeführt werden.

12. Verfahren nach einem der Ansprüche 1 bis 11, **dadurch gekennzeichnet, daß** bei der Herstellung der vertikalen Opferschicht mindestens eine die Opferschicht unterbrechende Anbindungsfahne aus Resistmaterial hergestellt wird.

13. Verfahren nach einem der Ansprüche 1 bis 12, **dadurch gekennzeichnet, daß** während der Herstellung des Mikrobauteils eine das Mikrobauteil über die mindestens eine Anbindungsfahne haltende Magazinstruktur aus Resistmaterial hergestellt wird.

14. Verfahren nach einem der Ansprüche 1 bis 13, **dadurch gekennzeichnet, daß** mindestens zwei Mikrobauteile in einer Magazinstruktur gleichzeitig hergestellt werden.

15. Verfahren nach einem der Ansprüche 1 bis 14, **dadurch gekennzeichnet, daß** als Magazinstruktur ein Wafer hergestellt wird.

16. Freitragende Flachspule für Mikromotoren mit mindestens einer Wicklungslage mit Leiterbahnen im sub-Millimeterbereich, **dadurch gekennzeichnet, daß** die Leiterbahnen in isolierendes und mittels UV-Strahlung strukturierbares und vernetzbares Resistmaterial eingebettet sind.

17. Flachspule nach Anspruch 16, **dadurch gekennzeichnet, daß** die Leiterbahnen (4) an eine aus dem Resistmaterial herausgeführte metallische AnschluBfläche angeschlossen sind.

18. Flachspule nach Anspruch 16 oder 17, **dadurch gekennzeichnet, daß** mindestens ein Armierungselement in das Resistmaterial eingebettet ist oder das Resistmaterial umgibt.

19. Flachspule nach einem der Ansprüche 16 bis 18, **dadurch gekennzeichnet, daß** die Resiststrukturen zwischen den Leiterbahnen (4) eine Breite von 5 bis 15 µm und eine Höhe von 40 bis 80 µm aufweisen.

## Claims

1. Lithographic process for the fabrication of microcomponents with metallic component structures in the sub-millimeter range, in which a resist material is structured by means of selective exposure and dissolving out of the unexposed areas and the gaps between the resist structures are filled by means of a galvanic process with metal for forming of the metallic component structures, **characterized in that**
during the fabrication of the microcomponent a three dimensionally structured metallic sacrificial layer is fabricated, which borders the microcomponent, and that the sacrificial layer will be removed for the separation of the microcomponent.

2. Process according to claim 1, **characterized in that** the three dimensionally structured sacrificial layer is composed of at least one horizontal sacrificial layer and at least one vertical sacrificial layer.

3. Process according to one of the claims 1 or 2, **characterized in that** the structures for the vertical sacrificial layer will be formed during the structuring of the resist material.

4. Process according to one of the claims 1 through 3, **characterized in that** the same metal will be used for the metallic component structures and for the three dimensionally structured sacrificial layer.

5. Process according to one of the claims 1 through 4, **characterized in that** the galvanic deposition for the formation of the component structures and the galvanic deposition for the vertical sacrificial layer will be conducted simultaneously.

6. Process according to one of the claims 1 through 5, **characterized in that** the resist material surrounding the metallic component structures will not be removed.

7. Process according to one of the claims 1 through 6, **characterized in that** the conductive strips of a flat coil will be fabricated as metallic component structures.

8. Process according to claim 7, **characterized in that** for the fabrication of conductive strips, structured initial layers will be employed for the ensuing galvanic deposition.

9. Process according to one of the claims 7 or 8, **characterized in that** conductive strips will be fabricated with an aspect ratio of >1.

10. Lithographic process for the fabrication of microcomponents with component structures of cross-linkable resist material, **characterized in**
a) that a horizontal, metallic sacrificial layer will be applied on a substratum,
b) that the resist material will be applied on the sacrificial layer,
c) that the component structures will be fabricated from the resist material by means of selective exposure and dissolving out of the unexposed areas,
d) that the gaps between the component structures will be filled with metal for the formation of at least one vertical sacrificial layer by means of a galvanic process, and
e) that the sacrificial layers will be removed for separation of the microcomponents,

11. Process according to claim 10, **characterized in that** the steps b) to d) will be carried out in this order at least two times.

12. Process according to one of the claims 1 through 11, **characterized in that** during the fabrication of the vertical sacrificial layer at least one binding flag interrupting the sacrificial layer will be fabricated of resist material.

13. Process according to one of the claims 1 through 12, **characterized in that** during the fabrication of the microcomponent a magazine structure keeping the microcomponent by means of at least one binding flag is fabricated of resist material.

14. Process according to one of the claims 1 through 13, **characterized in that** at least two microcomponents are fabricated simultaneously in one magazine structure.

15. Process according to one of the claims 1 through 14, **characterized in that** a wafer will be fabricated as a magazine structure.

16. Unsupported flat coil for micromotors with at least one coil layer with conductive strips in the sub-millimeter range, **characterized in that** the conductive strips are embedded in isolating, and by means of UV radiation structurable and cross-linkable resist material.

17. Flat coil according to claim 16, **characterized in that** the conductive strips (4) are connected to a metallic terminal area led through out of the resist material.

18. Flat coil according to one of the claims 16 or 17, **characterized in that** at least one reinforcement element is embedded in the resist material, or surrounds it.

19. Flat coil according to one of the claims 16 through 18, **characterized in that** the resist structures between the conductive strips (4) have a width between 5 and 15µm and a height between 40 to 80µm.

## Revendications

1. Procédé lithographique pour la fabrication de micro-éléments avec structures métalliques submillimétriques, dans lequel un matériau résistant est structuré au moyen d'une insolation sélective et par élimination des zones non insolées, et dans lequel les espaces entre les structures résistantes sont remplies de métal par traitement galvanique de manière à former des structures métalliques, ledit procédé étant **caractérisé en ce qu'**il se forme une couche sacrificielle métallique à structure tridimensionnelle limitant le micro-élément pendant la fabrication des micro-éléments, et **en ce que** la couche sacrificielle est éliminée pour la séparation du micro-élément.

2. Procédé selon la revendication 1,
**caractérisé en ce que** la couche sacrificielle è structure tridimensionnelle est formée d'au moins une couche sacrificielle horizontale et d'au moins une couche sacrificielle verticale.

3. Procédé selon la revendication 1 ou 2, **caractérisé en ce que** les structures de la couche sacrificielle verticale se forment également lors de la structuration du matériau résistant.

4. Procédé selon l'une des revendications 1 à 3, **caractérisé en ce que** le même métal est utilisé pour les structures métalliques et pour la couche sacrificielle à structure tridimensionnelle.

5. Procédé selon l'une des revendications 1 à 4, **caractérisé en ce que** la déposition galvanique pour la formation des structures d'éléments et la déposition galvanique pour la couche sacrificielle verticale sont réalisées simultanément.

6. Procédé selon l'une des revendications 1 à 5, **caractérisé en ce que** le matériau résistant entourant les structures métalliques des éléments n'est pas éliminé.

7. Procédé selon l'une des revendications 1 à 6, **caractérisé en ce que** des pistes conductrices d'une bobine plate sont réalisées en tant que structures métalliques des éléments.

8. Procédé selon la revendication 7, **caractérisé en ce que** des couches de lancement structurées sont utilisées pour la fabrication des pistes conductrices pour la déposition galvanique postérieure.

9. Procédé selon la revendication 7 ou 8, **caractérisé en ce que** les pistes conductrices sont fabriquées avec un rapport d'aspect >1.

10. Procédé lithographique pour la fabrication de micro-éléments à structures en matériau résistant réticulable, **caractérisé par** le fait :
a) qu'une couche sacrificielle métallique horizontale est appliquée sur un substrat,
b) qu'un matériau résistant est appliqué sur la couche sacrificielle,
c) que la structure des éléments est réalisée dans le matériau résistant au moyen d'une insolation sélective et par élimination des zones non insolées,
d) que les espaces entre les structures des éléments sont remplis de métal par traitement galvanique de manière à former au moins une couche sacrificielle verticale,
e) que les couches sacrificielles sont éliminées pour la séparation du micro-élément.

11. Procédé selon la revendication 10, **caractérisé en ce que** les étapes b) à d) sont réalisées au moins deux fois de suite dans la chronologie indiquée.

12. Procédé selon les revendications 1 à 11, **caractérisé en ce que**, lors de la fabrication de la couche sacrificielle verticale, au moins une liaison d'entrée coupant la couche sacrificielle est réalisée en matériau résistant.

13. Procédé selon l'une des revendications 1 à 12, **caractérisé en ce que**, lors de la fabrication du micro-élément, une structure de magasin maintenant le micro-élément au-dessus d'au moins une liaison d'entrée est réalisée en matériau résistant.

14. Procédé selon l'une des revendications 1 à 13, **caractérisé en ce qu'**au moins deux micro-éléments sont fabriqués simultanément dans une « structure de magasin ».

15. Procédé selon l'une des revendications 1 à 14, **caractérisé en ce qu'**une plaquette est fabriquée en tant que « structure de magasin ».

16. Bobine plate en porte-à-faux pour micromoteurs, pourvue d'au moins un espace d'enroulement avec pistes conductrices submillimétriques, **caractérisée en ce que** les pistes conductrices sont noyées dans un matériau résistant à pouvoir isolant, susceptible d'être réticulé et structuré à l'aide de rayons UV.

17. Bobine plate selon la revendication 16, **caractérisée en ce que** les pistes conductrices (4) sont reliées à une surface de connexion en métal issu du matériau résistant.

18. Bobine plate selon la revendication 16 ou 17, **caractérisée en ce qu'**au moins un élément d'armure est incorporé dans ou entoure le matériau résistant.

19. Bobine plate selon l'une des revendications 16 à 18, **caractérisée en ce que** les structures résistantes entre les pistes conductrices (4) mesurent 5 à 15 µm de large et 40 à 80 µm de haut.
